# EUROPEAN PATENT APPLICATION

(11) **EP 4 642 197 A1**
(43) Date of publication of application: **29.10.2025**
(21) Application number: 23907807.4
(22) Date of filing: 21.12.2023
(51) Int. Cl.: H10K 50/11, H10K 50/81, H10K 50/82, H10K 50/15, H10K 50/16, H10K 50/17, H10K 50/13, H10K 50/19

(54) **ORGANIC ELECTROLUMINESCENT DEVICE**

(30) Priority: 23.12.2022 KR 20220183791
(71) Applicant: Solus Advanced Materials Co., Ltd., Iksan-si, Jeollabuk-do 54584 (KR)
(72) Inventor: MOON, Jonghun, Bundang-gu, Gyeonggi-do 13636 (KR); KIM, Taehyung, Seongnam-si, Gyeonggi-do 13636 (KR); LEE, Jaehoon, Seongnam-si, Gyeonggi-do 13636 (KR); PARK, Hocheol, Seongnam-si, Gyeonggi-do 13636 (KR); HAN, Songie, Seongnam-si, Gyeonggi-do 13636 (KR)
(74) Representative: Office Freylinger
(86) International application number: PCT/KR2023/021257
(87) International publication number: WO 2024/136524

(57) **Abstract**

The present invention provides an organic electroluminescent element having improved characteristics, such as low driving voltage, high luminous efficiency, and long service life, due to comprising a hybrid-electron transport layer including a dimer controlled to have predetermined physical properties.

## Description

### Technical Field

The present invention relates to an organic electroluminescent device having improved characteristics, such as low driving voltage, high luminous efficiency, and long lifespan, by including a hybrid electron transport layer containing a dimer controlled to have predetermined properties.

### Background Art

In 1965, studies on organic EL devices led to blue electroluminescence which uses anthracene monocrystals, and in 1987, Tang suggested an organic EL device in a two-layered stack structure which includes a hole layer (NPB) and a light emitting layer (Alq3). Afterwards, in order to realize high efficiency and long life characteristics required for commercialization of organic EL devices, a multilayer stack structure that includes, for example, organic layers responsible for hole injection and transporting, organic layers responsible for electron injection and transporting, and an organic layer responsible for inducing combination of the holes and electrons to cause electroluminescence, each having distinctive and subdivided functions, has been suggested. The introduction of the multilayer stack structure improved the performance of the organic EL devices up to the level of commercialization, and such a multilayer stack structure has been expanding its application range from portable radio display products in 1997 to portable information display devices and TV display devices.

The demand for larger displays and higher resolutions has led to challenges, for example, high efficiency and long lifespan, for the organic EL devices. Particularly, the high resolution that may be realized by forming more pixels in the same area results in a decrease in a light emitting area of an organic EL pixel, thus inevitably reducing the lifespan, which has become one of the most important technical challenges to overcome for the organic EL device.

In the organic EL device, when current or voltage is applied to two electrodes, holes are injected into an organic layer at an anode, and electrons are injected into the organic layer at a cathode. When the injected holes and electrons meet, an exciton is formed, and the exciton falls to the ground state, resulting in light emission. Such organic EL devices may be classified, according to an electron spin type of the formed excitons, into fluorescent EL devices in which singlet excitons contribute to light emission and phosphorescent EL devices in which triplet excitons contribute to light emission.

In terms of the electron spin of the excitons that are formed by recombination of electrons and holes, 25 % of singlet excitons and 75 % of triplet excitons are produced. In the fluorescent EL devices which emit light by singlet excitons, the internal quantum efficiency may not theoretically exceed 25 % depending on the production ratio, and the external quantum efficiency is regarded to have a limitation of 5 %. The phosphorescent EL devices which emit light by triplet excitons may improve luminous efficiency by up to four times as compared to fluorescence, when metal complex compounds containing transition metal heavy atoms such as Ir and Pt are used as phosphorescent dopants.

As described above, although the phosphorescent EL devices exhibit higher efficiency than fluorescence in terms of luminous efficiency based on the theoretical fact, in the case of blue phosphorescent devices, except green and red, the development level for phosphorescent dopants having deep blue color purity and high efficiency and hosts having a broad energy gap to satisfy such phosphorescent dopants is insufficient, and thus blue phosphorescent devices have not been commercialized yet, and blue fluorescent devices have been used in products.

In order to improve such characteristics of the organic EL device, research results to increase the stability of the organic EL device by preventing diffusion of holes into an electron transferring layer have been reported. However, to date, no satisfactory result has been obtained.

### Disclosure of Invention

### Technical Problem

The present invention has been made to solve the above-mentioned problems, and an aspect of the present invention is to provide an organic EL device having exhibiting high luminous efficiency, low driving voltage, and long lifespan, by including, as one component of an electron transport area having at least two layers, a hybrid electron transport layer containing a dimer controlled to have predetermined properties.

Other purposes and advantages of the present disclosure will be clarified by following detailed description and claims.

### Solution to Problem

To achieve the above objectives, the present invention provides an organic electroluminescent device comprising an anode, a hole transport area, a light emitting layer, an electron transport area, and a cathode, which are sequentially laminated,
the electron transport area including a hybrid electron transport layer (hybrid ETL),
the hybrid electron transport layer containing a dimer derived from at least two types of organic materials including a first monomer and a second monomer,
wherein the LUMO density of states (LUMO-DOS^{Dimer}) of the hybrid electron transport layer may include:
   (i) LUMO density of states 1 (LUMO-DOS^{ET1}) of the first monomer;
   (ii) LUMO density of states 1-1 (LUMO-DOS^{ET1_ET1_Dimer}) of a first homodimer;
   (iii) LUMO density of states 2 (LUMO-DOS^{ET2}) of the second monomer;
   (iv) LUMO density of states 2-2 (LUMO-DOS^{ET2_ET2_Dimer}) of a second homodimer; and
   (v) LUMO density of states 3 (LUMO-DOS^{ET1_ET2_Dimer}) of a third heterodimer composed of the first monomer and the second monomer, and
   (vi) the absolute value of the LUMO energy level of the first monomer may be lower than the absolute value of the LUMO energy level of the second monomer, and
   (vii) the LUMO density of states 3 (LUMO-DOS^{ET1_ET2_Dimer}) of the third heterodimer may overlap at least one of the LUMO density of states 1 (LUMO-DOS^{ET1}) of the first monomer and the LUMO density of states 2 (LUMO-DOS^{ET2}) of the second monomer.

According to an embodiment, the LUMO density of states 3 (LUMO-DOS^{ET1_ET2_Dimer}) of the third heterodimer may overlap at least one of the LUMO density of states 1-1 (LUMO-DOS^{ET1_ET1_Dimer}) of a first homodimer and the LUMO density of states 2-2 (LUMO-DOS^{ET2_ET2_Dimer}) of a second homodimer.

According to an embodiment, the absolute value difference between the LUMO energy level (ET1_LUMO) of the first monomer and the LUMO energy level (ET2_LUMO) of the second monomer may be greater than 0 eV and 2.0 eV or less.

According to an embodiment, the overlap rate of the LUMO density of states 3 (LUMO-DOS^{ET1_ET2_Dimer}) of the third heterodimer and the LUMO density of states 2 (LUMO-DOS^{ET2}) of the second monomer may be greater than 0% and 80% or less.

According to an embodiment, the dimer contains the first monomer and the second monomer and may be formed by co-deposition of the first and second monomers.

According to an embodiment, the hybrid electron transport layer may be an organic layer free from a metal complex.

According to an embodiment, the electron transport area may include at least two layers, which include: a hybrid electron transport layer; and at least one of an auxiliary electron transport layer and an electron injection layer.

According to an embodiment, the auxiliary electron transport layer may be disposed between the light emitting layer and the hybrid electron transport layer, and the electron injection layer may be disposed between the hybrid electron transport layer and the cathode.

According to an embodiment, at least one of the LUMO densities of states (LUMO-DOS^{Dimer}) of the hybrid electron transport layer may overlap the LUMO density of states (LUMO-DOS^{AETL}) of the auxiliary electron transport layer.

According to an embodiment, an absolute value of a difference between a LUMO energy of the first monomer and a LUMO energy of the auxiliary electron transport layer may be greater than 0 eV and 1.5 eV or less.

According to an embodiment, an absolute value of a difference between a LUMO energy of the second monomer and a work function of the cathode may be greater than 0.5 eV and 2.5 eV or less.

According to an embodiment, the absolute value of a difference in molecular weight (MW) between the first monomer and the second monomer may be from 0 to 600 g/mol.

According to an embodiment, a triple energy (T1) of the hybrid electron transport layer may be 1.5 eV or higher.

According to an embodiment, a single energy (S1) of the hybrid electron transport layer may be 2.0 eV or higher.

According to an embodiment, an absolute value of a HOMO energy level of the hybrid electron transport layer may be from 0 to 4.0 eV.

According to an embodiment, a lowest energy level among a bonding dissociation energy (BDE) of a ground state of the hybrid electron transport layer may be 0.8 eV or more.

According to an embodiment, the hybrid electron transport layer (Hybrid-ETL) may have a refractive index (n) of 0.7 or more in a blue wavelength region of 400 to 470 nm.

According to an embodiment, a difference in refractive index between the first monomer and the second monomer in a blue wavelength region of 400 to 470 nm is 0 to 2.

According to an embodiment, the hybrid electron transport layer may have a dipole moment greater than 0.

According to an embodiment, the hybrid electron transport layer may have an electronic affinity (EA) of 0.2 eV or more.

According to an embodiment, the hybrid electron transport layer may have an electron mobility (µ) of at least 1×10⁻⁸ cm²/Vs or more in a zero-field.

According to an embodiment, the light emitting layer includes the host and a dopant, and a mixing ratio between the host and the dopant may be 70-99.5 : 0.5-30 by weight.

In some embodiments, the organic electroluminescent device may include a plurality of light emitting layer stacks including at least one light emitting layer.

### Advantageous Effects of Invention

According to an embodiment of the present invention, an organic electroluminescent device can be provided exhibiting low driving voltage, high efficiency, and long lifespan through the suppression of hole/electron leakage and efficient injection of carriers from an electrode by providing, as one component of an electron transport area, a hybrid electron transport layer (hybrid-ETL) containing a dimer, which is formed by the bonding of at least two molecules and controlled to have predetermined properties.

The effects according to the present invention are not limited by the contents exemplified above, and more various effects are included in the present specification.

### BRIEF DESCRIPTION OF DRAWINGS

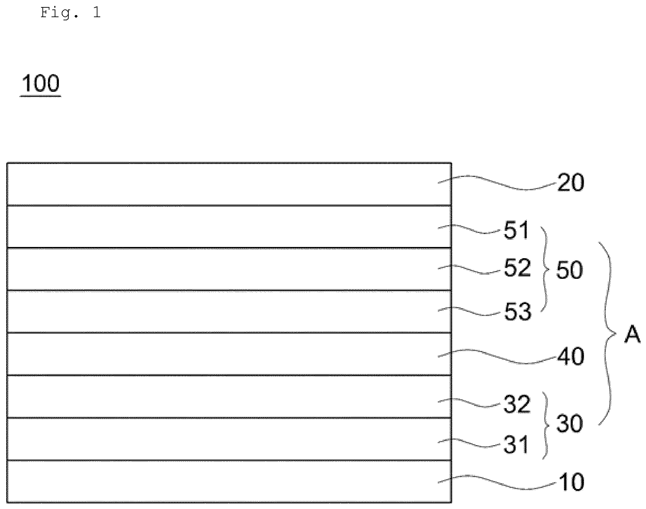

FIG. 1 is a cross-sectional view illustrating a structure of an organic EL device according to an embodiment of the present invention.

### [Reference signs]

- 100:: Organic electroluminescent device
- A:: Organic layer
- 10:: an anode
- 20:: a cathode
- 30:: a hole transport area
- 31:: a hole injection layer
- 32:: a hole transport layer
- 40:: a light emitting layer (an emissive layer)
- 50:: an electron transport area
- 51:: an electron injection layer
- 52:: a hybrid electron transport layer
- 53:: an auxiliary electron transport layer

### DETAILED DESCRIPTION OF THE INVENTION

Advantages and features of the present invention and methods for achieving them will become apparent with reference to the embodiments described below in detail in conjunction with the accompanying drawings. However, the present invention is not limited to the embodiments disclosed below but may be implemented in various different forms, the present embodiments are merely provided to make the disclosure of the present invention complete and to fully convey the scope of the present invention to those of ordinary skill in the art, and the present invention is defined only by the scope of the claims. Thus, in some embodiments, well-known process steps, well-known device structures and well-known techniques are not described in detail in order to avoid obscuring the present invention. Like reference numerals refer to like elements throughout the specification.

Unless otherwise defined, all terms used in the present specification (including technical and scientific terms) may be used with meanings that may be commonly understood by those skilled in the art. In addition, the terms defined in the commonly used dictionaries are not ideally or excessively interpreted, unless they are specifically defined clearly.

In addition, throughout the specification, when a part is said to "include" an element, it means that it may further include another element, not excluding other elements, unless otherwise stated. In addition, throughout the specification, "above" or "on" means not only the case where it is located above or below a target part but also the case where there is another part in the middle thereof and does not necessarily mean the upward direction of gravity. As used herein, the terms "first", "second", and the like are used to distinguish elements from each other, rather than indicating any order or importance.

Throughout this specification, "density of states DOS" may be defined as the number of allowed states at a particular energy level, such as HOMO and LUMO, that electrons are allowed to occupy and a HOMO density of states HOMO-DOS and a LUMO density of states LUMO-DOS of each material may be obtained in the following scheme.

### <Organic electroluminescent device>

Hereinafter, preferred embodiments of the organic EL device according to the present invention will be described with reference to the accompanying drawings. However, embodiments of the present invention may be modified in various other forms, and the scope of the present invention is not limited to the embodiments described below.

FIG. 1 is a cross-sectional view illustrating a structure of an organic EL device 100 according to a first embodiment of the present invention.

Referring to FIG. 1, the organic electroluminescent device 100 comprises an anode 10, a cathode 20, a light emitting layer 40 disposed between the anode 10 and the cathode 20, a hole transport area 30 disposed between the anode 10 and the light emitting layer 40, and an electron transport area 50 disposed between the light emitting layer 40 and the cathode 20, wherein the electron transport area 50 include, as one layer of at least two layers, a hybrid electron transport layer (Hybrid-ETL) 52 containing a dimer derived from at least two organic material monomers, the LUMO density of states (LUMO-DOS) of the dimer being controlled to a specific range.

The accumulation of electrons/holes in the light emitting layer (e.g., host) causes the occurrence of a leakage in which the electrons/holes move or diffuse to an adjacent layer, thereby adversely affecting the efficiency and lifespan characteristics of the device. In the conventional art, in order to prevent the above-described leakage, a functional layer composed of a single organic molecule, for example, a hole leakage suppression layer, was disposed between the light emitting layer and the electron transport area, or two kinds of organic materials was simply mixed and used. However, such cases could not achieve a desired improvement in efficiency. Additionally, in the conventional art, a metal complex, such as Liq, was contained as a component of the electron transport layer, but such a case requires a separate process for handling the metal complex.

In the present invention, the hybrid electron transport layer 52 containing a dimer derived from at least two kinds of organic materials is disposed as one layer of at least two layers of the electron transport area 50, and the hybrid-electron transport layer of the present invention is differentiated from the conventional electron transport layer containing a single molecule or a metal complex (Liq) together with the single molecule. Particularly, the hybrid electron transport layer 52 of the present invention does not contain a metal or metal complex and is fully composed of an organic material layer, so that the aforementioned problems due to the use of metals are fundamentally resolved, and rapid electron transport from the electrode to hosts of the light emitting layer 40 can be achieved through the control of various energy levels of the applied organic materials.

Additionally, the electrons move along the energy levels of LUMO. As for LUMO-DOS, the LUMO density of states (DOS) of a conventional electron transport layer composed of a single molecule (e.g., ET1) is limited to the LUMO-DOS of a first monomer (e.g., ET1) or a first dimer that is homogeneous (e.g., a first homodimer, ET1-ET1), and thus electron transport occurs according to the overlap of these one or two LUMO-DOSs.

In contrast, the hybrid electron transport layer 52 according to the present invention contains at least two kinds of organic molecules, for example, a first monomer (e.g., ET1) and a second monomer (ET2), or is formed by a combination of these monomers. This hybrid electron transport layer 52 contains not only two types of monomers (e.g., ET1 and ET2) but also various types of dimers (e.g., ET1-ET1, ET2-ET2, ET1-ET2, etc.) derived therefrom, and thus various monomer LUMO-DOSs (e.g., LUMO-DOS^{ET1}, LUMO-DOS^{ET2}), homodimer LUMO-DOSs (e.g., LUMO-DOS^{ET1_ET1_Dimer}, LUMO-DOS^{ET2_ET2_Dimer}) , and heterodimer LUMO-DOS (e.g., LUMO-DOS^{ET1_ET2_Dimer}) coexist in the electron transport area. Unlike a metal complex (e.g., Liq) having a single energy level, the above-described homodimer and heterodimer LUMO-DOSs are generated and exist as new energy levels between the existing LUMO-DOSs of the first and second monomers (e.g., LUMO-DOS^{ET1}, LUMO-DOS^{ET2}), and the distribution of these dimer LUMO-DOSs serves as a bridge for electron transport, thereby increasing the prompt electron transport effect from an electrode to hosts. Such a distribution of various monomer LUMO-DOSs and dimer LUMO-DOSs relatively increases the overlap rate between these densities of states, and especially, the presence or absence of a particular range of (LUMO-DOS^{ET1_ET2_Dimer}) of the heterogeneous dimers (heterodimer) further increases the efficient electron transport effect from the hybrid electron transport layer 52 to hosts, thereby implementing a synergistic effect in improved efficiency, low driving voltage, and long lifespan of the organic electroluminescent device.

In an embodiment, the hybrid electron transport layer (hybrid-ETL, 52) contains a dimer derived from at least two types of organic materials including a first monomer and a second monomer, wherein the LUMO density of states (LUMO-DOS^{Dimer}) of the hybrid electron transport layer includes: (i) LUMO density of states 1 (LUMO-DOS^{ET1}) of the first monomer; (ii) LUMO density of states 1-1 (LUMO-DOS^{ET1_ET1_Dimer}) of a first homodimer that is homogeneous; (iii) LUMO density of states 2 (LUMO-DOS^{ET2}) of the second monomer; (iv) LUMO density of states 2-2 (LUMO-DOS^{ET2_ET2_Dimer}) of a second homodimer that is homogeneous; and (v) LUMO density of states 3 (LUMO-DOS^{ET1_ET2_Dimer}) of a third heterodimer that is heterogeneous, (vi) the absolute value of the LUMO energy level of the first monomer is lower than the absolute value of the LUMO energy level of the second monomer, and (vii) the LUMO density of states 3 (LUMO-DOS^{ET1_ET2_Dimer}) of the third heterodimer overlaps at least one of the LUMO density of states 1 (LUMO-DOS^{ET1}) of the first monomer and the LUMO density of states 2 (LUMO-DOS^{ET2}) of the second monomer.

The overlap rate (overlap degree) between the LUMO density of states 3 (LUMO-DOS^{ET1_ET2_Dimer}) of the third heterodimer and the LUMO density of states 1 (LUMO-DOS^{ET1}) of the first monomer, or between the LUMO density of states 3 (LUMO-DOS^{ET1_ET2_Dimer}) of the third heterodimer and the LUMO density of states 2 (LUMO-DOS^{ET2}) of the second monomer is not particularly limited and can be appropriately controlled considering the above-described carrier mobility. For example, the overlap rate may exceed 0%, specifically, 0% (exclusive) to 100% (inclusive), and more specifically, 1 to 95%. In the present invention, it may be preferable that at least parts of the LUMO density of states 3 (LUMO-DOS^{ET1_ET2_Dimer}) of the third heterodimer, the LUMO density of states 1 (LUMO-DOS^{ET1}) of the first monomer, and the LUMO density of states 2 (LUMO-DOS^{ET2}) of the second monomer overlap simultaneously.

In another embodiment, the LUMO density of states 3 (LUMO-DOS^{ET1_ET2_Dimer}) of the third heterodimer may overlaps at least one of the LUMO density of states 1-1 (LUMO-DOS^{ET1_ET1}) of the first homodimer that is homogeneous and the LUMO density of states 2-2 (LUMO-DOS^{ET2-ET2}) of the second homodimer that is homogeneous.

In such a case, the overlap rate (overlap degree) between the LUMO density of states 3 (LUMO-DOS^{ET1_ET2_Dimer}) of the third heterodimer and the LUMO density of states 1 (LUMO-DOS^{ET1-ET1}) of the first homodimer or between the LUMO density of states 3 (LUMO-DOS^{ET1_ET2_Dimer}) of the third heterodimer and the LUMO density of states 2-2 (LUMO-DOS^{ET2-ET2}) of the second homodimer is not particularly limited, and may be appropriately controlled considering the above-described carrier mobility. For example, the overlap rate may exceed 0%, specifically, 0% (exclusive) to 100% (inclusive), and more specifically, 1 to 95%. Specifically, it may be preferable that at least parts of the LUMO density of states 3 (LUMO-DOS^{ET1_ET2_Dimer}) of the third heterodimer, the LUMO density of states 1 (LUMO-DOS^{ET1-ET1}) of the first homodimer, and the LUMO density of states 2-2 (LUMO-DOS^{ET2-ET2}) of the second homodimer may overlap simultaneously.

In another embodiment, the overlap rate of the LUMO density of states 3 (LUMO-DOS^{ET1_ET2_Dimer}) of the third heterodimer and the LUMO density of states (LUMO-DOS^{ET2}) of the second monomer, which has the largest absolute value in the hybrid electron transport layer (Hybrid-ETL, 52), is greater than 0% (exclusive) and 80% or less (inclusive), and specifically 0% (exclusive) to 50% (inclusive).

Meanwhile, at least one of the LUMO densities of states (LUMO-DOS^{Dimer}) of the dimers of the hybrid electron transport layer 52 may overlap the LUMO density of states (LUMO-DOS^{ETL}) of one portion of the electron transport area 50, specifically, the auxiliary electron transport layer 53 adjacent the light emitting layer, in at least two layers of the electron transport area. As such, the generation of the densities of states with new energy levels due to the dimers is more advantageous in the electron mobility between the hybrid electron transport layer 52 and the electron transport auxiliary layer 53, leading to an enhanced synergistic effect. The LUMO density of states (LUMO-DOS) overlap rate between the electron transport area 50 and the hybrid electron transport layer 52 is not particularly limited and may be appropriately controlled considering the above-described property improvement effect. Particularly, when the electron transport area 50 has a multilayer structure, the overlapped one region of the electron transport area 50 may indicate a layer that is directly in contact with the hybrid electron transport layer 52.

In one embodiment, the absolute value of a difference between the LUMO energy level of the first monomer, which has a smaller absolute value in the hybrid electron transport layer (hybrid-ETL, 52), and the LUMO energy level of the auxiliary electron transport layer 53 may be greater than 0 eV (exclusive) and 1.5 eV or less (inclusive), specifically 0.05 to 1.0 eV.

In another embodiment, the absolute value of a difference between the LUMO energy level of the second monomer, which has the highest absolute value in the hybrid electron transport layer (hybrid-ETL), and the work function of the cathode 20 may be greater than 0.5 eV (exclusive) and 2.5 eV or less (inclusive), specifically 1.0 to 2.0 eV.

In order to achieve low driving voltage and high efficiency along with the above-described control of LUMO density of states (LUMO DOS) overlap of the dimers and the resultant leakage prevention and increase in electron mobility, the hybrid electron transport layer (hybrid-ETL, 52) according to the present invention preferably further satisfies at least one of the following properties.

In an embodiment, a singlet energy S1 of the hybrid electron transport layer (Hybrid-ETL, 52) may be 2.0 eV or more, specifically 2.0 to 4.5 eV, and more specifically 2.0 to 4.0 eV. In such a case, phenomena that singlet excitons diffuse to an adjacent interface and/or another layer or that luminescence occurs at an interface may be suppressed, and the singlet excitons may be effectively bonded. Accordingly, an amount of excitons is increased, and thus the luminous efficiency of the organic EL device may be improved. As a result, it is possible to prevent spectral mixing of the organic EL device to improve stability, and thus the efficiency and lifespan of the organic EL device may be improved.

In another embodiment, a triplet energy T1 of the hybrid electron transport layer (Hybrid-ETL, 52) may be 1.5 eV or more, specifically 1.5 to 4.5 eV, and more specifically 1.5 to 4.0 eV. In such an embodiment, excitons may be prevented from moving to other layers, and thus the efficiency of the organic EL device may be significantly improved.

In another embodiment, the absolute values of the HOMO (Highest occupied Molecular Orbital) energy of the hybrid electron transport layer (Hybrid-ETL, 52) may be 4.0 eV or more, and specifically, 4.0 to 7.0 eV, and more specifically, 4.0 to 6.5 eV. If the HOMO energy value is such, it is possible to block the phenomenon in which the holes transferred to the light emitting layer 40 diffuse or cross into other electron transport area, for example, the electron transport layers 51. Accordingly, the efficiency of the organic electroluminescent device may be further increased by increasing the probability of recombination of the holes and electrons encounter in the light emitting layer 40. In addition, the irreversible decomposition reaction caused by oxidation when the holes diffuse or migrate to the electron transport layer 51 beyond the light emitting layer 40 and the lifetime of the organic electroluminescent device may be reduced, thereby improving the lifetime characteristics of the device.

In another embodiment, the absolute values of the LUMO (Lowest Unoccupied Molecular Orbital) energy of the hybrid electron transport layer (Hybrid-ETL, 52) may be 1.0 eV or more, and specifically, 1.0 to 3.5 eV, and more specifically, 1.0 to 3.0 eV, respectively. In addition, in order to generate efficient and high efficiency, the band gap energy of the hybrid electron transport layer (Hybrid-ETL, 52) may be 2.0 eV or more, and specifically, 2.0 to 4.5 eV.

In another embodiment, a lowest energy level of bond dissociation energy BDE of each of the hybrid electron transport layer (Hybrid-ETL, 52) in a ground state may be 0.8 eV or more, specifically 1.0 to 6.0 eV, and more specifically 1.5 to 6.0 eV. In such an embodiment, the bond dissociation energy BDE may be interpreted as an energy required to break a specific chemical bond. In general, the bond dissociation energy BDE is related to stability of molecules as the bond is stronger, and thus acts as a factor affecting the lifespan.

In another embodiment, an electron affinity EA of the hybrid electron transport layer (Hybrid-ETL, 52) may be at least 0.2 eV or more, specifically 0.5 to 3.0 eV. In the case where the hybrid electron transport layer 52 has the aforementioned electron affinity, high electron injection efficiency may be obtained.

In another embodiment, when the light emitting layer 40 is a blue light emitting layer including a fluorescent blue light emitting material, the hybrid electron transport layer (hybrid-ETL, 52) may have a refractive index (n) of at least 0.7 or more in a blue wavelength region of 400 to 470 nm, and specifically 0.7 to 3.5.

In another embodiment, a dipole moment of the hybrid electron transport layer (Hybrid-ETL, 52) may be more than 0, and specifically, 0 to 10.

If electrons and holes are not balanced due to a difference between the number of holes injected from the anode 10 and the number of electrons injected from the cathode 20, the electrons or holes that fail to form excitons by recombination may be accumulated in the light emitting layer 40. The electrons or holes accumulated in the light emitting layer 40 interfere with smooth oxidation and reduction from occurring in the light emitting layer 40, or affect adjacent layers, and thus the lifespan of the organic EL device may be reduced. On the other hand, the hybrid electron transport layer (Hybrid-ETL, 52) has an electron mobility (µ) of at least 1×10⁻⁸ cm²/Vs or more at room temperature, such that the delay of the injection of electrons as compared to the number of holes injected from the anode 10 is prevented, and the injection of electrons into the light emitting layer 40 becomes smooth. Accordingly, efficiency of exciton formation in the light emitting layer 40 is increased, and thus the lifespan of the organic EL device may be improved.

Hereinafter, the configuration of the organic EL device 100 according to one embodiment of the present invention including the hybrid electron transport layer (Hybrid-ETL, 52) will be described in more detail.

### An anode

In the organic electroluminescent device 100 according to the present invention, the anode 10 serves as an anode that injects holes into an organic material layer A.

A material forming the anode (a first electrode, 10) is not particularly limited, and conventional materials known in the art may be used. Non-limiting examples thereof may include metals such as vanadium, chromium, copper, zinc and gold; alloys thereof; metal oxides such as zinc oxide, indium oxide, indium tin oxide (ITO) and indium zinc oxide (IZO); a combination of a metal and an oxide such as ZnO:Al and SnO2:Sb; conductive polymers such as polythiophene, poly(3-methylthiophene), poly[3,4-(ethylene-1,2-dioxy) thiophene] (PEDT), polypyrrole and polyaniline, and carbon black.

A method of manufacturing the anode 10 is also not particularly limited and it may be prepared according to conventional methods known in the art. As an example, a method of coating an anode material on a substrate formed of a silicon wafer, quartz, a glass plate, a metal plate or a plastic film may be used.

### a cathode

In the organic electroluminescent device 100 according to the present invention, the cathode 20 serve as a cathode that injects electrons into the organic material layer A.

A material forming the cathode 20 is not particularly limited, and conventional materials known in the art may be used. Non-limiting examples thereof may include metals such as magnesium, calcium, sodium, potassium, titanium, indium, yttrium, lithium, gadolinium, aluminum, silver, tin, and lead, alloys thereof, and multilayer-structured materials such as LiF/Al and LiO₂/Al.

In addition, a method of manufacturing the cathode 20 is not also particularly limited and it may be prepared according to conventional methods known in the art.

### ORGANIC LAYER

The organic layer A included in the organic EL device according to the present invention may use, without limitation, any conventional configuration used in an organic layer of conventional organic EL devices, and may include, for example, one or more selected from the hole transport area 30, the light emitting layer 40, and the electron transport area 50. In such a case, in consideration of the characteristics of the organic EL device, it is preferable to include all the above-mentioned organic layers.

### HOLE TRANSPORT AREA

The hole transport area 30 included in the organic layer A of the present invention serves to transfer holes injected from the anode 10 to the light emitting layer 40. The hole transport area 30 may include one or more layers including at least one the hole injection layer 31 and the hole transport layer 32 described above. Considering the characteristics of the organic EL device, it is preferable to include all of the hole injection layer 31 and the hole transport layer 32.

In the present invention, materials for the hole injection layer 31 and/or the hole transport layer 32 are not particularly limited, and any hole injection/transport layer material known in the art may be used without limitation, as long as it has a low hole injection barrier and a high hole mobility. In such a case, the materials forming the hole injection layer 31 and the hole transport layer 32 may be the same as or different from each other.

The hole injection material may use, without limitation, any hole injection material known in the art. Non-limiting examples of the hole injection material may include phthalocyanine compounds such as copper phthalocyanine; DNTPD (N,N'-diphenyl-N,N'-bis-[4-(phenyl-m-tolyl-amino)-phenyl]-biphenyl-4,4'-diamine), m-MTDATA (4,4',4"-tris(3-methylphenylphenylamino)triphenylamine), TDATA (4,4'4"-Tris(N,N-diphenylamino)triphenylamine), 2TNATA (4,4',4"-tris{N-(2-naphthyl)-N-phenylamino}-triphenylamine), PEDOT/PSS (poly(3,4-ethylenedioxythiophene)/poly(4-styrenesulfonate)), PANI/DBSA (polyaniline/dodecylbenzenesulfonic acid), PANI/CSA (polyaniline/camphor sulfonic acid), PANI/PSS (polyaniline)/poly(4-styrenesulfonate)), and the like, which may be used solely or as a mixture of two or more thereof.

And the hole transporting material may use, without limitation, any hole transporting material known in the art. Non-limiting examples of the hole transporting material may include carbazole-based derivatives such as phenylcarbazole, polyvinylcarbazole or the like; fluorine-based derivatives; triphenylamine-based derivatives such as TPD (N,N'-bis(3-methylphenyl)-N,N'-diphenyl-[1,1-biphenyl]-4,4'-diamine), TCTA (4,4',4"-tris(N-carbazolyl)triphenylamine) or the like; NPB (N,N'-di(1-naphthyl)-N,N'-diphenylbenzidine), TAPC(4,4'-cyclohexylidene bis[N,N-bis(4-methylphenyl)benzenamine]), and the like, which may be used solely or as a mixture of two or more thereof.

The hole transport area 30 may be formed through any conventional method known in the art. Examples of the method may include, but are not limited to, a vacuum deposition method, a spin coating method, a cast method, a Langmuir-Blodgett (LB) method, an inkjet printing method, a laser printing method, a laser-induced thermal imaging (LITI) method, and the like.

### LIGHT EMITTING LAYER

The light emitting layer 40 included in the organic layer A of the present invention is a layer in which holes and electrons meet each other forming excitons, and a color of light emitted by the organic EL device may vary according to the material forming the light emitting layer 40.

Such a light emitting layer 40 may include a host and a dopant, and a mixing ratio thereof may be appropriately adjusted within a range known in the art. For example, the light emitting layer 40 may include the host in an amount ranging from 70 to 99.9 parts by weight and the dopant in an amount ranging from 0.1 to 30 parts by weight, with respect to the total weight of the light emitting layer 40. More specifically, when the light emitting layer 40 is blue fluorescence, green fluorescence, or red fluorescence, the host may be included in an amount ranging from 80 to 99.9 parts by weight, and the dopant may be included in an amount ranging from 0.1 to 20 parts by weight. In addition, when the light emitting layer 40 is blue fluorescence, green fluorescence or red phosphorescence, the host may be included in an amount ranging from 70 to 99 parts by weight and the dopant may be included in an amount ranging from 1 to 30 parts by weight.

Any host known in the art may be included in the light emitting layer 40 of the present invention without particular limitation, and non-limiting examples thereof may include alkali metal complex compounds, alkaline earth metal complex compounds, or fused aromatic cyclic derivatives.

More specifically, the host material is preferably aluminum complex compounds, beryllium complex compounds, anthracene derivatives, pyrene derivatives, triphenylene derivatives, carbazole derivatives, dibenzofuran derivatives, dibenzothiophene derivatives, or a combination of one or more kinds thereof that may enhance luminous efficiency and lifespan of the organic EL device.

In addition, any dopant known in the art may be included in the light emitting layer 40 of the present invention without particular limitation, and non-limiting examples thereof may include anthracene derivatives, pyrene derivatives, arylamine derivatives, and metal complex compounds including iridium (Ir) or platinum (Pt).

Such dopants may be classified into red dopants, green dopants, and blue dopants, and any conventional red dopants, green dopants, and blue dopants that are known in the art may be used without particular limitation.

More specifically, non-limiting examples of the red dopant may include PtOEP (Pt(II) octaethylporphyrin), Ir(piq)3 (tris(2-phenylisoquinoline)iridium), Btp2Ir(acac) (bis(2-(2'-benzothienyl)-pyridinato-N,C3')iridium(acetylacetonate)), or a mixture of two or more thereof.

Furthermore, non-limiting examples of the green dopant may include Ir(ppy)3 (tris(2-phenylpyridine)iridium), Ir(ppy)2(acac)(bis(2-phenylpyridine) (acetylacetonato)iridium(III)), Ir(mppy)3 (tris(2-(4-tolyl)phenylpiridine)iridium), C545T (10-(2-benzothiazolyl)-1,1,7,7-tetramethyl-2,3,6,7-tetrahydro-1H,5H,11H-[1]benzopyrano[6,7,8-1ij]-quinolizin-11-one), or a mixture of two or more thereof.

Furthermore, non-limiting examples of the blue dopant may include F2Irpic (bis[3,5-difluoro-2-(2-pyridyl)phenyl](picolinato)iridium(III)), (F2ppy)2Ir(tmd), Ir(dfppz)3, DPVBi (4,4'-bis(2,2'-diphenylethen-1-yl)biphenyl), DPAVBi (4,4'-bis[4-(diphenylamino)styryl]biphenyl), TBPe (2,5,8,11-tetra-tert-butylperylene), or a mixture of two or more thereof.

The light emitting layer 40 according to the present invention may be a red light emitting layer including a red phosphorescent material, a green light emitting layer including a green phosphorescent material; or a blue light emitting layer including a blue phosphorescent material or a blue fluorescent material. The light emitting layer 40 may preferably be a light emitting layer including a blue fluorescent material.

The light emitting layer 40 may include a single layer including one type of material, a single layer including a plurality of different materials, or a multi-layer of at least two layers, each including different materials from each other. When the light emitting layer 40 includes a plurality of layers, the organic EL device may emit light having various colors. Specifically, the present invention may provide an organic EL device having mixed colors by including a plurality of light emitting layers, including different kinds of materials, in series. In addition, when the light emitting layer 40 includes a plurality of light emitting layers, the driving voltage of the device may increase, while the current value in the organic EL device become constant, and thus the organic EL device may have luminous efficiency that is improved by the number of the light emitting layers.

Although not illustrated in the drawings, the organic EL device 100 may include a plurality of light emission stacks (not illustrated) including at least one light emitting layer.

The plurality of light emitting layers included in the light emission stack may be light emitting layers that emit light of different colors, or light emitting layers that emit light of the same color. That is, the emission color may vary depending on the material forming the light emitting layer. For example, the plurality of light emission stacks may include a material emitting blue, green, red, yellow, white, or the like, and may be formed using phosphorescent or fluorescent materials. In this case, the colors represented by the light emitting layers may be complementary to each other. In addition, a color may be selected as a combination of colors capable of emitting white light. Each of the light emitting layers may include phosphorescent dopants or fluorescent dopants corresponding to the selected color, respectively.

Although not illustrated in the drawings, the organic EL device 100 may further include a charge generation layer CGL (not illustrated) disposed between adjacent stacks of the plurality of light emission stacks and connecting them.

The charge generation layer CGL means a layer, in the organic EL device including a plurality of light emission stacks, that separates light emission stacks adjacent to each other without directly contacting both electrodes (e.g., anode and cathode). Such a charge generation layer CGL is disposed between two adjacent light emission stacks, generating electrons to serve as a cathode for one light emission stack, and generating holes to serve as an anode for another light emission stack. The charge generation layer CGL may use, without limitation, any material that may be used as a charge generation layer material known in the art. In addition, a conventional n-type and/or p-type material known in the art may be doped to the above material for the charge generation layer.

### ELECTRON TRANSPORT AREA

In the organic EL device 100 according to the present invention, the electron transport area 50 included in the organic layer A serves to transfer electrons injected from the cathode 20 to the light emitting layer 40.

The electron transport area 50 may include two or more layers, including the hybrid electron transport layer 52 and at least one layer selected from the group consisting of an electron injection layer 51 and an auxiliary electron transport layer 53, and may further include a hole leakage suppression layer (not illustrated) if necessary.

Specifically, the electron transport area 50 may have a structure in which the hybrid electron transport layer 52 and the electron injection layer 51 are disposed with respect to the light emitting layer or a structure in which the auxiliary electron transport layer 53, the hybrid electron transport layer 52 and the electron injection layer 51 are disposed with respect to the light emitting layer. Considering characteristics of the organic EL device, it is preferable to include all of the auxiliary electron transport layer 53, the hybrid electron transport layer 52 and the electron injection layer 51.

As long as the hybrid electron transport layer 52 according to the present invention satisfies the above-described LUMO densities of states of the dimers (e.g., LUMO-DOS^{Dimer}) and overlap parameters thereof, the hybrid electron transport layer 52 is not particularly limited to the detailed configuration of the dimers, for example, the structure of at least two types of organic material monomers (e.g., first and second monomers) constituting the dimers, the types of moieties contained in the organic material monomers (e.g., EDG and EWG) and bonding positions thereof, the type of linker and the introduction position thereof, and the composition therebetween.

The hybrid electron transport layer 52 contains a dimer derived from at least two organic material monomers. In such a case, the dimer is a dimeric molecular material formed by the bonding or polymerization (association) of two single molecules, wherein the single molecules include all typical organic material monomers capable of forming a dimer in the art.

The first and second monomers capable of forming a dimer may be each a typical monomer known in the art, and these may be different from each other. The first organic material and the second organic material may form a dimer through co-deposition, and dimers formed by other typical methods known in the art fall within the scope of the present invention. Particularly, the first monomer and the second monomer need to form a more stable dimer through bonding or polymerization (association). To this end, it is preferable to control the first monomer and the second monomer to have predetermined properties as follows.

In an embodiment, the absolute value of a difference between the LUMO energy level (ET1_LUMO) of the first monomer and the LUMO energy level (ET2_LUMO) of the second monomer constituting the hybrid electron transport layer (Hybrid-ETL, 52) may be greater than 0 eV and 2.0 eV or less, and specifically 0.05 to 1.5 eV.

In another embodiment, the absolute value of a difference between the molecular weight (MW) of the first monomer and the second monomer may be 0 to 600 g/mol, and specifically 0 to 400 g/mol.

In another embodiment, the difference between the refractive index of the first monomer and the second monomer in the blue wavelength region of 400 to 470 nm may be 0 to 2, and specifically 0 to 1.5.

And the first monomer and the second monomer used as the material of the hybrid electron transport layer 52 may be a compound bonded with at least one moiety, known in the art, having EWG characteristics with high electron absorptivity, respectively, and may be, for example, a bipolar compound including both of a moiety having EWG characteristics with high electron absorptivity and a moiety having EDG characteristics with high electron donating properties.

More specifically, each of the first monomer and the second monomer constituting a dimer in the hybrid electron transport layer 52 may include at least one EWG moiety including at least one of a 6-membered moiety represented by the following Chemical Formula 1; a 5-membered moiety represented by the following Chemical Formula 2; and a polycyclic moiety in which the 6-membered moiety and the 5-membered moiety are fused.

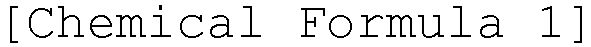

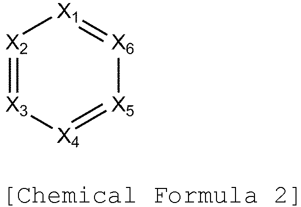

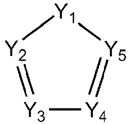

In Formula 1 or 2,
X₁ to X₆ and Y₁ to Y₅ may be the same as or different from each other, each independently being N or C(R), while at least one of X₁ to X₆ and Y₁ to Y₅ is N,
when C(R) is plural in number, the plurality of R may be the same as or different from each other, each independently being selected from the group consisting of: hydrogen, deuterium, a halogen group, a cyano group, a nitro group, an amino group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a C₆ to C₆₀ arylphosphine group, a C₆ to C₆₀ arylphosphine oxide group and a C₆ to C₆₀ arylamine group, or may be bonded with an adjacent group to form a fused ring,
the alkyl group, the alkenyl group, the alkynyl group, the aryl group, the heteroaryl group, the aryloxy group, the alkyloxy group, the cycloalkyl group, the heterocycloalkyl group, the arylamine group, the alkylsilyl group, the alkylboron group, the arylboron group, the arylphosphine group, the arylphosphine oxide group, and the arylamine group of R may each independently be substituted with one or more kinds of substituents selected from the group consisting of hydrogen, deuterium (D), halogen, a cyano group, a nitro group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a C₆ to C₆₀ arylphosphine group, a C₆ to C₆₀ arylphosphine oxide group and a C₆ to C₆₀ arylamine group, and when the substituents are plural in number, the substituents may be the same as or different from each other.

Each of the first monomer and the second monomer constituting a dimer contained in the hybrid electron transport layer 52 exhibits excellent electronic properties by including at least one nitrogen (N)-containing heteroaromatic ring containing nitrogen (N), that is, an EWG (electron withdrawing group). Accordingly, when the first organic compound and the second organic compound having the 6-membered or 5-membered moiety represented by Chemical Formula 1 or 2, or having a polycyclic moiety in which they are fused are used as a material for the hybrid electron transport layer 52 may well receive electrons from the cathode 20 to transfer the electrons to the light emitting layer 40 smoothly, and accordingly, the driving voltage of the device 100 may be reduced and high efficiency and long life of the device 100 may be resulted.

In addition, the material of the dimer included in the hybrid electron transport layer 52 not only has a high triplet energy, but also has a molecular weight of the compound significantly increased through the control of various types of substituents introduced into a mother nucleus and location of the introduction, and thus an improved glass transition degree and high thermal stability may be achieved. In addition, since it is also effective in suppressing crystallization of the organic layer, the organic EL device 100 including the first electron transport layer 51 and the second electron transport layer 52 may greatly improve durability and lifespan characteristics.

According to an embodiment of the present invention, the EWG moiety included in each of the first monomer and the second monomer may be the same as or different from each other, and each independently may be more embodied as any one of the following structural formulas. However, the present invention is not particularly limited thereto. 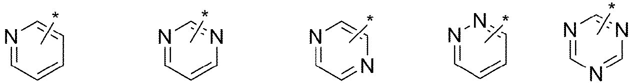 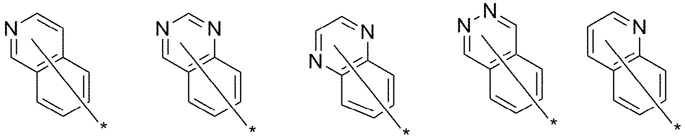 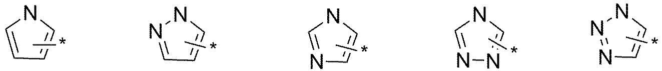 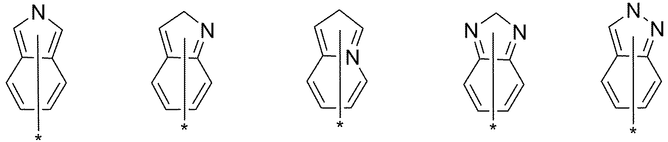 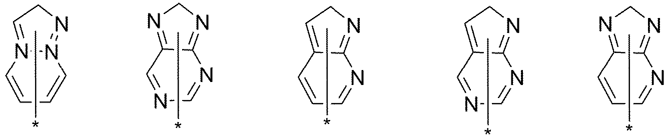 In the above formulas,
* means a site where a bond is made with the first monomer and/or the second monomer constituting the hybrid electron transport layer 52.

Although not specifically indicated in the above structural formulas, at least one or more substituents (e.g., the same as the definition of R) known in the art may be substituted. In addition, although one site * connected to the compound forming the hybrid electron transport layer 52 is shown in the structural formula, it will be understood that a case where two sites are included is within the scope of the present invention.

In an embodiment according to the present invention, each of the first monomer and the second monomer forming the dimer included in the hybrid electron transport layer 52 may include at least one conventional EDG moiety known in the pertinent art, other than the aforementioned EWG, that has higher electron donating properties than that of the EWG.

The first monomer and the second monomer which may be used as materials of the dimer for the hybrid electron transport layer 52 according to the present invention described above may be more specifically formed by the exemplary compounds described below. However, the first monomer and the second monomer constituting the hybrid electron transport layer 52 according to the present invention are not limited by those exemplified below. In particular, as long as properties such as the overlap ratio of the dimer LUMO density of states (LUMO-DOS^{Dimer}) are satisfied, the type of moiety (e.g., EDG or EWG) contained in the first monomer and the second monomer, and binding position thereof, introduction position of a linker are not particularly limited, and compounds with variously modified chemical structures fall within the scope of the present invention.

The hybrid electron transport layer 52 according to the present invention may be manufactured through conventional methods known in the art. Examples thereof may include a vacuum deposition method, spin coating method, cast method, LB (Langmuir-Blodgett), inkjet printing method, laser printing method, LITI (Laser Induced Thermal Imaging) and the like, but are not limited thereto.

In the electron transport area 50 according to the present invention, the auxiliary electron transport layer 53 and/or the electron injection layer 51 used together with the hybrid electron transport layer (Hybrid-ETL, 52) are not particularly limited as long as electron injection is easy and electron mobility is high, and the electron transport layer/electron transport layer materials commonly used in the art may be used without limitation.

Non-limiting examples of electron injection materials that may be used include anthracene derivatives, heteroaromatic compounds, alkali metal complexes, and the like. Specifically, examples thereof may include lanthanum group metals such as LiF, Li2O, BaO, NaCl, CsF, Yb and the like; or a metal halide such as RbCl, RbI, or the like, which may be used solely or in combination of two or more thereof.

And the auxiliary electron transport layer 53 may be used a material having general electron transport characteristics known in the art without limitation. For example, the oxadiazole derivative, the triazole derivative, the phenanthroline derivative (e.g., BCP), the heterocyclic derivative including nitrogen, and the like may be included.

The electron transport area 50 according to the present invention, specifically the electron injection layer 53 may be co-deposited with a n-type dopant to facilitate the injection of electrons from the cathode. In this case, an alkali metal complex compound known in the art may be used without limitation as the n-type dopant, and examples thereof may include an alkali metal, an alkaline earth metal or a rare earth metal.

The electron transport area 50 may be formed by, but are not limited to, a vacuum deposition method, a spin coating method, a cast method, a Langmuir-Blodgett (LB) method, an inkjet printing method, a laser printing method, a laser-induced thermal imaging (LITI) method, and the like.

### light emitting auxiliary layer

Optionally, the organic EL device 100 according to the present invention may further include a light emitting auxiliary layer (not illustrated) disposed between the hole transport area 30 and the light emitting layer 40.

The light emitting auxiliary layer serves to transfer holes migrating from the hole transport area 30 to the light emitting layer 40 and to control a thickness of the organic layer A. The light emitting auxiliary layer has a high LUMO value to prevent electrons from moving to the hole transport layer 32 and has a high triplet energy to prevent the excitons of the light emitting layer 40 from diffusing into the hole transport layer 32.

The auxiliary light emitting layer may include a hole transporting material and may include a material the same as a material for the hole transport area. In addition, the auxiliary light emitting layers of the red, green, and blue organic EL devices may be formed of the same material.

The material of the light emitting auxiliary layer is not particularly limited, and examples thereof may include carbazole derivatives and arylamine derivatives. Non-limiting examples of the auxiliary light emitting layer that are applicable may include NPD (N, N-dinaphthyl-N, N'-diphenyl benzidine), TPD (N, N'-bis-(3-methylphenyl)-N, N'-bis(phenyl)- benzidine), s-TAD, and MTDATA(4,4',4-Tris(N-3-methylphenyl-Nphenyl-amino)-triphenylamine). They may be used solely or in combination of two or more thereof. In addition, the auxiliary light emitting layer may include a p-type dopant, in addition to the above materials. As the p-type dopant, any well-known p-type dopant used in the art may be used.

### Capping layer

Optionally, the organic EL device 100 of the present invention may further include a capping layer (not illustrated) disposed on the second electrode 20 described above. The capping layer serves to protect the organic EL device and to help light emitted from the organic layer to be efficiently emitted to the outside.

The capping layer may include at least one selected from the group consisting of tris-8-hydroxyquinoline aluminum (Alq3), ZnSe, 2,5-bis(6'-(2',2"-bipyridyl))-1,1-dimethyl-3,4-diphenylsilole, 4'-bis [N-(1-napthyl)-N-phenyl-amion] biphenyl (α-NPD), N,N'-diphenyl-N,N'-bis (3-methylphenyl)-1,1'-biphenyl-4,4'-diamine (TPD), and 1,1'-bis(di-4-tolylaminophenyl) cyclohexane (TAPC). A material forming such a capping layer is less expensive than materials of other layers of the organic EL device.

The capping layer may be a single layer, or may include two or more layers having different refractive indices so that the refractive index gradually changes along the two or more layers.

The capping layer may be manufactured by a conventional method known in the art, and for example, various methods such as vacuum deposition, spin coating, casting, or Langmuir-Blodgett (LB) method may be used.

The organic EL device of the present invention including the above-described configuration may be manufactured according to conventional methods known in the art. For example, the organic EL device may be manufactured by vacuum depositing an anode material on a substrate and then vacuum depositing a material of the hole transport area, a material of the light emitting layer, a material of the electron transport area, and a material of the cathode on the anode in the order.

Meanwhile, FIG. 1 exemplary illustrates that the first monomer and the second monomer are used for the dimers contained in the hybrid electron transport layer 52. However, the present invention is not limited to the above-described configuration, and at least three kinds of organic materials constitute a dimer, a trimer, or a higher multimer, which is then contained in the hybrid electron transport layer 52, and these multimers fall within the scope of the present invention.

The organic EL devices 100 according to the present invention described above have a structure in which the anode 10, the organic material layer A, and the cathode 20 are sequentially stacked, and an insulating layer or an adhesive layer may be further included between the anode 10 and the organic material layer A or between the cathode 20 and the organic material layer A. Such an organic EL device of the present invention may have excellent lifespan characteristics since the lifetime (e.g., half-time) of the initial brightness is increased while maintaining the maximum luminous efficiency when voltage, current, or both are applied.

Hereinafter, the present invention will be described in detail through examples. However, the following examples are only to illustrate the present invention, and the present invention is not limited by the following examples.

### [Preparation (Calculation) Example]

The compounds according to the present invention were prepared as follows, and their physical properties were measured by methods known in the art, respectively, which are shown in Table 1 below.

The HOMO energy, the LUMO energy, the singlet energy S1, the triplet energy T1 and the like of the material used in the present invention were calculated using a Schrödinger program (Schrödinger software release 2022-3). Specifically, the basic calculation scheme of each property used the B3LYP functional (Becke, 3-parameter, Lee-Yang-Parr) which is most widely used among density functional theories (DFT), and TZV (triple zeta) was used as a basis set to optimize the molecular structure.

The HOMO energy and the LUMO energy of each compound were calculated in the ground state S0 with the optimized structure, and each of the singlet energy S1 and the triplet energy T1 was calculated based on the optimized energy difference between the ground state S0/singlet energy S1 and ground state S0/triplet energy T1.

Additionally, molecular dynamics and quantum mechanics were used for the density of states (DOS). First, simulations were conducted on hundreds of molecules (100 ns or higher) through molecular dynamics, and then HOMO and LUMO energies of all molecules were extracted through quantum mechanics, respectively, on the basis of which the densities of states (DOSs) were obtained. The DOS overlap rates between dimers and monomers were quantified as a percentage. Additionally, the comparison of the energy sum of each monomer with the total energy of dimers could easily predict the likelihood of dimer formation. Furthermore, considering the π-π stacking interaction of dimers, calculation was performed on dimers with an inter-distance of 5 Å or less from the structural center. Particularly, the dimer calculation was performed using ωB98XD, which is a dispersion corrected DFT method.

In addition, a bond dissociation energy (BDE), a refractive index, and a dipole moment were obtained using the aforementioned B3LYP/TZV method, and in particular, for the BDE, an energy required to break a certain chemical bond in a molecule is calculated, and a value having a smallest BDE was selected.

**[Table 1]**

| **Compounds** | | **HOMO** | **LUMO** | **Dimer_ET1-ET2 overlap ratio (%)** | | | | **S1 energy (eV)** | **T1 energy (eV)** | **Refractive index (at 450nm)** | **BDE (eV)** | **Dipole moment (Debye)** |
|---|---|---|---|---|---|---|---|---|---|---|---|---|
| | | | | **ET1** | **ET1-ET1** | **ET2** | **ET2-ET2** | | | | | |
| 1 | ET1-1 | -5.65 | -2.30 | 0 | 3 | 22 | 5 | 3.06 | 2.56 | 1.97 | 2.57 | 3.08 |
| | ET2-1 | -6.56 | -2.61 | | | | | 3.46 | 2.52 | 2.07 | 2.44 | 7.71 |
| 2 | ET1-2 | -5.34 | -2.32 | 7 | 18 | 39 | 15 | 2.78 | 2.48 | 2.01 | 2.75 | 3.01 |
| | ET2-2 | -6.37 | -2.46 | | | | | 3.48 | 2.60 | 2.14 | 2.24 | 7.19 |
| 3 | ET1-3 | -6.17 | -2.29 | 0 | 6 | 28 | 0 | 3.55 | 3.00 | 2.52 | 2.52 | 1.09 |
| | ET2-3 | -6.26 | -2.51 | | | | | 3.31 | 2.52 | 2.07 | 2.34 | 6.51 |
| 4 | ET1-4 | -6.06 | -2.35 | 0 | 5 | 35 | 0 | 3.46 | 2.70 | 2.01 | 2.09 | 3.80 |
| | ET2-4 | -6.05 | -2.73 | | | | | 3.07 | 2.48 | 2.03 | 1.98 | 6.63 |
| 5 | ET1-5 | -6.29 | -2.35 | 3 | 13 | 32 | 11 | 3.51 | 2.49 | 2.13 | 2.20 | 5.79 |
| | ET2-5 | -6.29 | -2.48 | | | | | 3.43 | 2.45 | 2.01 | 2.35 | 6.50 |
| 6 | ET1-6 | -6.27 | -2.38 | 0 | 4 | 30 | 0 | 3.54 | 2.41 | 2.09 | 2.47 | 3.97 |
| | ET2-6 | -6.11 | -2.61 | | | | | 3.14 | 2.43 | 1.98 | 2.46 | 5.74 |
| 7 | ET1-7 | -6.24 | -2.33 | 12 | 41 | 48 | 19 | 3.44 | 2.46 | 2.05 | 2.87 | 3.87 |
| | ET2-7 | -5.65 | -2.40 | | | | | 2.78 | 2.79 | 2.33 | 2.01 | 2.84 |
| AE | | -5.90 | -2.22 | | | | | 3.37 | 2.71 | 1.98 | 2.49 | 0.57 |
| ET | | -6.08 | -2.34 | | | | | 3.33 | 2.28 | 1.89 | 3.75 | 5.57 |
| BH | | -5.44 | -1.91 | | | | | 3.21 | 1.78 | 1.94 | 4.17 | 0.66 |

The structure of each compound used in Table 1 above is as follows.

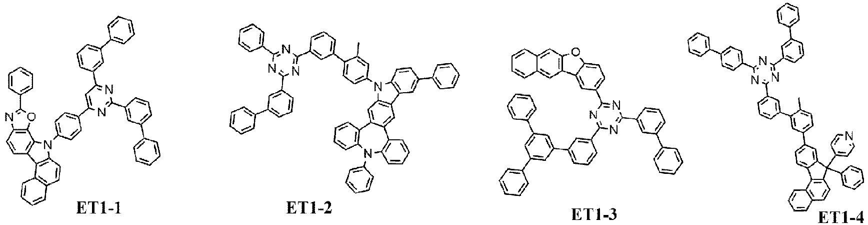

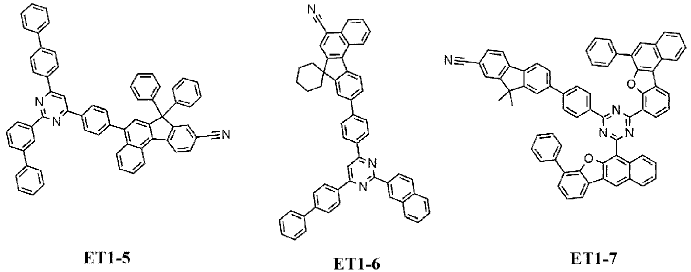

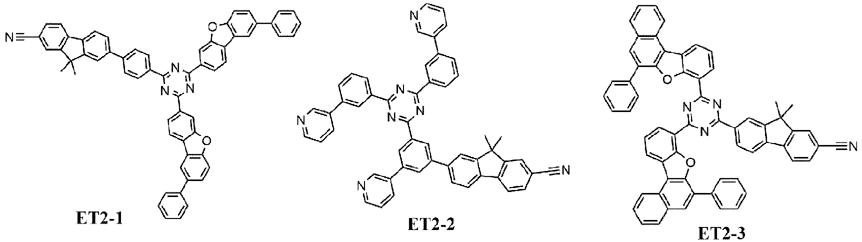

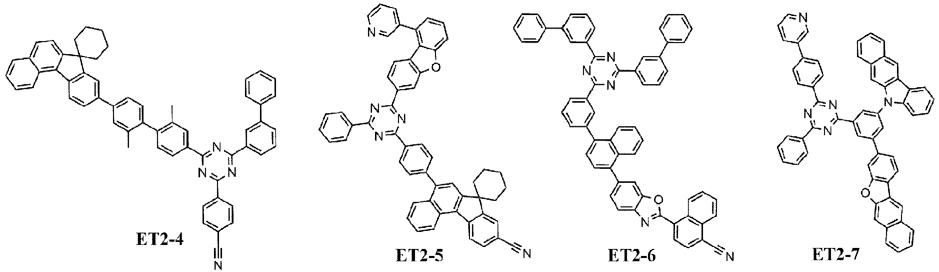

### [Examples 1 to 8] Manufacturing of Blue organic EL device

Each compound wase subjected to high-purity sublimation purification in a conventionally known method, and then blue organic EL device was manufactured according to the following procedure.

A glass substrate thin-film-coated with indium tin oxide (ITO) to a thickness of 1,200 Å was washed with distilled water ultrasonically. After washing with distilled water was completed, the glass substrate was ultrasonically washed with a solvent, such as isopropyl alcohol, acetone and methanol, dried, transferred to a UV OZONE cleaner (Power sonic 405, Hwasin Tech), cleaned for 5 minutes using UV, and then transferred to a vacuum evaporator.

On the ITO transparent electrode prepared as above, HI+2 wt% HD (100 Å)/HI(1400 Å)/HT (50 Å)/BH + 2 wt% BD(200 Å)/AE (50 Å) / ET1+ET2 in Table 2 (300 Å_1:1)/LiF (10 Å)/Al (1000 Å) were stacked in order to manufacture an organic EL device as shown in Table 2.

**[Table 2]**

| | Compounds | Thickness (nm) |
|---|---|---|
| A hole injection layer | HI | 140 |
| A hole transport layer | HT | 5 |
| A light emitting layer | BH + 2% BD | 20 |
| An auxiliary electron transport layer | AE | 5 |
| A hybrid electron transport layer | Each compound Second_A~G in Table 1 | 30 |
| An electron injection layer | LiF | 1 |
| A Cathode (a second | Al | 100 |
| electrode) | | |

### [Comparative Example 1]

An organic electroluminescent device of Comparative Example 1 was manufactured in the same manner as in Example 1, except that ET + Liq (300 Å_1:1) was used instead of the compounds ET1 and ET2 as materials for the hybrid-electron transport layer.

For reference, the structures of the compounds HI, HD, HT, BH, BD, AE and ET used in Examples 1 to 7 and Comparative Example 1 are as follows.

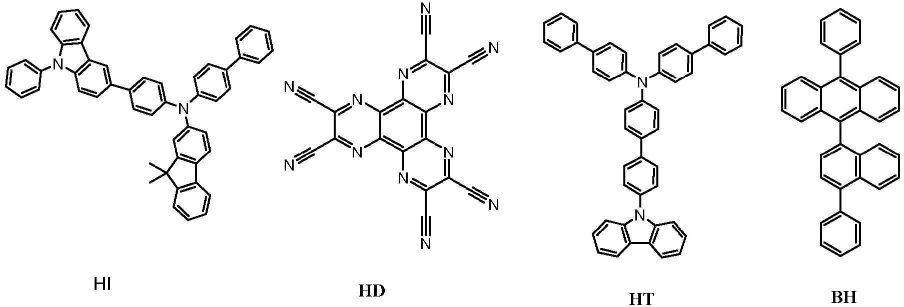

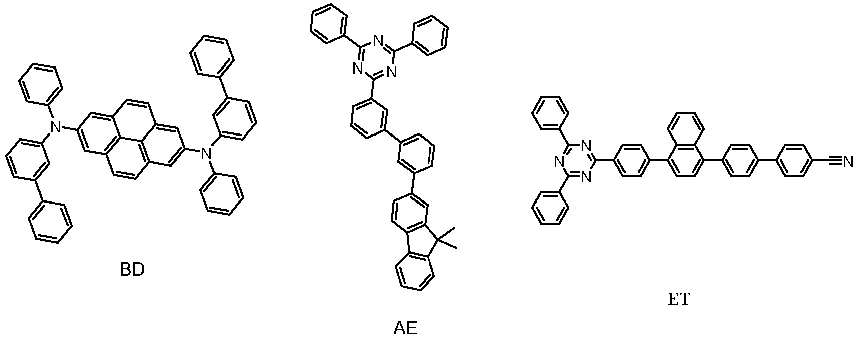

### [Evaluation Example 3]

For each of the organic EL devices manufactured in Examples (Ex.) 1 to 7 and Comparative Example (Comp. Ex.) 1, a driving voltage, and a current efficiency at a current density of 10 mA/cm² were measured, and the results are shown in Table 3 below.

**[Table 3]**

| Examples | Hybrid electron transport layer | | Driving voltage (V) | Current efficiency (cd/A) |
|---|---|---|---|---|
| | A first organic compound | A second organic compound | | |
| Ex. 1 | ET1-1 | ET2-1 | 3.74 | 8.8 |
| Ex. 2 | ET1-2 | ET2-2 | 3.79 | 8.0 |
| Ex. 3 | ET1-3 | ET2-3 | 3.82 | 8.2 |
| Ex. 4 | ET1-4 | ET2-4 | 3.58 | 9.2 |
| Ex. 5 | ET1-5 | ET2-5 | 3.89 | 8.1 |
| Ex. 6 | ET1-6 | ET2-6 | 3.71 | 8.6 |
| Ex. 7 | ET1-7 | ET2-7 | 3.75 | 8.4 |
| Comp. Ex. 1 | ET+Liq | | 4.57 | 6.1 |

As shown in Table 3 above, the organic electroluminescent devices of Examples 1 to 7 including a hybrid electron transport layer containing a dimer controlled to have predetermined properties exhibited far superior performance in terms of current efficiency and driving voltage, compared with the blue organic electroluminescent device of Comparative Example 1 using a single organic molecule and a metal complex (Liq) as materials for an electron transport layer.

## Claims

1. An organic electroluminescent device comprising an anode, a hole transport area, a light emitting layer, an electron transport area, and a cathode, which are sequentially laminated,
the electron transport area including a hybrid electron transport layer (hybrid ETL),
the hybrid electron transport layer containing a dimer derived from at least two types of organic materials including a first monomer and a second monomer,
wherein the LUMO density of states (LUMO-DOS^{Dimer}) of the hybrid electron transport layer includes:
(i) LUMO density of states 1 (LUMO-DOS^{ET1}) of the first monomer;
(ii) LUMO density of states 1-1 (LUMO-DOS^{ET1_ET1_Dimer}) of a first homodimer;
(iii) LUMO density of states 2 (LUMO-DOS^{ET2}) of the second monomer;
(iv) LUMO density of states 2-2 (LUMO-DOS^{ET2_ET2_Dimer}) of a second homodimer; and
(v) LUMO density of states 3 (LUMO-DOS^{ET1_ET2_Dimer}) of a third heterodimer composed of the first monomer and the second monomer, and
(vi) the absolute value of the LUMO energy level of the first monomer is lower than the absolute value of the LUMO energy level of the second monomer, and
(vii) the LUMO density of states 3 (LUMO-DOS^{ET1_ET2_Dimer}) of the third heterodimer overlaps at least one of the LUMO density of states 1 (LUMO-DOS^{ET1}) of the first monomer and the LUMO density of states 2 (LUMO-DOS^{ET2}) of the second monomer.

2. The organic electroluminescent device of claim 1, wherein the LUMO density of states 3 (LUMO-DOS^{ET1_ET2_Dimer}) of the third heterodimer overlaps at least one of the LUMO density of states 1-1 (LUMO-DOQS^{ET1_ET1_Dimer}) of a first homodimer and the LUMO density of states 2-2 (LUMO-DOS^{ET2_ET2_Dimer}) of a second homodimer.

3. The organic electroluminescent device of claim 1, wherein the absolute value difference between the LUMO energy level (ET1_LUMO) of the first monomer and the LUMO energy level (ET2_LUMO) of the second monomer is greater than 0 eV and 2.0 eV or less.

4. The organic electroluminescent device of claim 1, wherein the overlap rate of the LUMO density of states 3 (LUMO-DOS^{ET1_ET2_Dimer}) of the third heterodimer and the LUMO density of states 2 (LUMO-DOS^{ET2}) of the second monomer is greater than 0% and 80% or less.

5. The organic electroluminescent device of claim 1, wherein the dimer contains the first monomer and the second monomer and is formed by co-deposition of the first and second monomers.

6. The organic electroluminescent device of claim 1, wherein the hybrid electron transport layer is an organic layer free from a metal complex.

7. The organic electroluminescent device of claim 1, wherein the electron transport area includes at least two layers, which include:
a hybrid electron transport layer; and
at least one of an auxiliary electron transport layer and an electron injection layer.

8. The organic electroluminescent device of claim 7, wherein the auxiliary electron transport layer is disposed between the light emitting layer and the hybrid electron transport layer, and
the electron injection layer is disposed between the hybrid electron transport layer and the cathode.

9. The organic electroluminescent device of claim 7, wherein at least one of the LUMO densities of states (LUMO-DOS^{Dimer}) of the hybrid electron transport layer overlaps the LUMO density of states (LUMO-DOS^{AETL}) of the auxiliary electron transport layer.

10. The organic electroluminescent device of claim 7, wherein the absolute value of a difference between the LUMO energy level of the first monomer and the LUMO energy level of the auxiliary electron transport layer is greater than 0 eV and 1.5 eV or less.

11. The organic electroluminescent device of claim 1, wherein the absolute value of a difference between the LUMO energy level of the second monomer and a work function of the cathode is greater than 0.5 eV and 2.5 eV or less.

12. The organic electroluminescent device of claim 1, wherein the absolute value of a difference in molecular weight (MW) between the first monomer and the second monomer is from 0 to 600 g/mol.

13. The organic electroluminescent device of claim 1, wherein a triplet energy (T1) of the hybrid electron transport layer (Hybrid-ETL) is 1.5 eV or higher.

14. The organic electroluminescent device of claim 1, wherein a single energy (S1) of the hybrid electron transport layer (Hybrid-ETL) is 2.0 eV or higher

15. The organic electroluminescent device of claim 1, wherein an absolute value of a HOMO energy level of the hybrid electron transport layer (Hybrid-ETL) is 4.0 eV or higher.

16. The organic electroluminescent device of claim 1, wherein a lowest energy level among a bonding dissociation energy (BDE) of a ground state of the hybrid electron transport layer is 0.8 eV or more.

17. The organic electroluminescent device of claim 1, wherein the hybrid electron transport layer (Hybrid-ETL) has a refractive index (n) of 0.7 or more in a blue wavelength region of 400 to 470 nm**.**

18. The organic electroluminescent device according to claim 1, wherein a difference in refractive index between the first monomer and the second monomer in a blue wavelength region of 400 to 470 nm is 0 to 2.

19. The organic electroluminescent device of claim 1, wherein the hybrid electron transport layer (Hybrid-ETL) has a dipole moment greater than 0.

20. The organic electroluminescent device of claim 1, wherein the hybrid electron transport layer (Hybrid-ETL) has an electronic affinity (EA) of 0.2 eV or more.

21. The organic electroluminescent device of claim 1, wherein the hybrid electron transport layer (Hybrid-ETL) has an electron mobility (µ) of at least 1×10⁻⁸ cm²/Vs or more in a zero-field.

22. The organic electroluminescent device of claim 1, wherein the light emitting layer includes a host and a dopant, and a mixing ratio of the host and dopant is 70-99.5: 0.5-30 in a weight ratio.

23. The organic electroluminescent device of claim 1,
comprising a plurality of light emitting layer stacks
including at least one light emitting layer.
